# EUROPEAN PATENT APPLICATION

(11) **EP 4 737 926 A1**
(43) Date of publication of application: **06.05.2026**
(21) Application number: 25782859.0
(22) Date of filing: 24.01.2025
(51) Int. Cl.: G01R 31/392, G01R 31/396, G01R 31/371, H02J 7/00

(54) **BATTERY MANAGEMENT SYSTEM AND BATTERY STATE OF HEALTH MANAGEMENT METHOD THEREFOR**

(30) Priority: 02.04.2024 KR 20240044649
(71) Applicant: LG Energy Solution, Ltd., Seoul 07335 (KR)
(72) Inventor: PARK, Myeonghui, Daejeon 34122 (KR)
(74) Representative: Plasseraud IP
(86) International application number: PCT/KR2025/001446
(87) International publication number: WO 2025/211554

(57) **Abstract**

Provided is a battery SoH management method for a battery management system, comprising the steps of: checking the SOH of each of a plurality of battery modules included in a battery pack; on the basis of at least some of the respective SoHs of the plurality of battery modules, checking one or more first battery modules, which are at least some of the plurality of battery modules; and rechecking the SoH of the one or more first battery modules by considering at least a portion of the margin capacity of the one or more first battery modules as an available capacity.

## Description

### Technical Field

This application claims priority to and benefit of Korean Patent Application No. 2024-0044649 filed on April 2, 2024 in the Korean Intellectual Property Office, the entire contents of which are incorporated herein by reference.

The present disclosure relates to a battery management system and a battery State of Health (SoH) management method thereof.

### Background Art

Generally, battery packs are manufactured to have a pack-module-cell hierarchical structure. More particularly, battery packs include a number of battery modules, and the battery modules may be configured to have a structure including a number of battery cells. In such a battery structure, State of Health (SoH) of the battery pack is estimated based on a battery module with the lowest SoH among battery modules the battery pack includes, and SoH of the battery module may also be estimated based on a battery cell with the lowest SoH among battery cells the battery module includes. The battery may be managed by a battery management system so that the battery may be used based on the estimated SoH.

Such a SoH estimation method helps to maintain uniform performance of battery packs or modules, reduces the risk of overload or overcharging, and allows for lifespan optimization and better performance estimation. However, there are also disadvantages to the method, one of them being, in the case of an aged battery module being replaced with a new module, unable to fully utilize the performance of the new module as the SoH of the battery pack is determined based on states of health (SoHs) of the remaining modules that have not been replaced. In addition, when only some battery modules are aging more rapidly, there is a problem of using the battery pack based on the aged battery modules despite other battery modules being in their normal states, which leads to a waste of performance potential.

### Detailed Description of the Invention

### Technical Goals

The present disclosure relates to a battery management system and a battery State of Health (SoH) management method thereof. More particularly, it is an object of the present disclosure to provide a battery SoH management method based on a margin capacity of a battery module or a battery cell.

The goals to be achieved by example embodiments of the present disclosure are not limited to the objects described above, and other objects may be inferred from the following example embodiments.

### Technical Solutions

According to an aspect, there is provided a battery State of Health (SoH) management method of a battery management system, the method may include identifying SoH of each of a plurality of battery modules included in a battery pack, identifying at least one first battery module of the plurality of battery modules, based on at least one of the SoH of each of the plurality of battery modules, and reconfirming SoH of the at least one first battery module by considering at least a portion of a margin capacity of the at least one first battery module as an available capacity.

The identifying of the at least one first battery module may include confirming that at least one piece of difference information between the SoH of each of the plurality of battery modules is equal to or greater than a first threshold value, based on at least one of the SoH of each of the plurality of battery modules, and identifying at least one battery module with below a SoH among battery modules corresponding to each of the at least one piece of difference information that is equal to or greater than the first threshold value as the at least one first battery module.

The identifying of the at least one first battery module may include confirming that at least one of the SoH of each of the plurality of battery modules is equal to or less than a second threshold value, based on the at least one of the SoH of each of the plurality of battery modules, and identifying at least one battery module corresponding to the SoH that is equal to or less than the second threshold value as the at least one first battery module.

The reconfirming of the SoH of the at least one first battery module may include identifying a first SoH corresponding to remaining battery modules, excluding the at least one first battery module, among the plurality of battery modules, identifying, based on the first SoH, at least a portion of a capacity to be considered as the available capacity, from the margin capacity, and reconfirming SoH of the at least one first battery module based on the at least the portion of the capacity to be considered as the available capacity.

According to an aspect, there is also provided a battery SoH management method, that may further include confirming that at least one SoH of the plurality of battery modules is equal to or less than a second threshold value, confirming that a percentage of a margin capacity considered as an available capacity of at least one battery module corresponding to the SoH that is equal to or less than the second threshold value is equal to or greater than a third threshold value, and forwarding replacement information related to a replacement of the battery pack to an admin terminal.

The identifying of the at least one first battery module may include confirming that at least one of the SoH of each of the plurality of battery modules is below a second threshold value, and confirming that at least one of remaining battery modules, excluding the at least one first battery module with SoH equal to or greater than the second threshold value, among the plurality of battery modules, is replaced with at least one second battery module.

Additionally, the confirming that at least one of the SoH of each of the plurality of battery modules is below the second threshold value may include forwarding replacement information related to a replacement of the at least one of the remaining battery modules to an admin terminal.

The reconfirming of the SoH of the at least one first battery module may include identifying a second SoH corresponding to the at least one second battery module, identifying, based on the second SoH, at least a portion of a capacity to be considered as the available capacity, from the margin capacity, and reconfirming SoH of the at least one first battery module based on the at least the portion of the capacity to be considered as the available capacity.

According to still another aspect, there is also provided a battery management system for managing a battery State of Health (SoH), the system may include a processor, and a memory configured to store at least one instruction. The processor may be configured to identify SoH of each of a plurality of battery modules included in a battery pack, identify at least one first battery module of the plurality of battery modules, based on at least one of the SoH of each of the plurality of battery modules, and reconfirm SoH of the at least one first battery module by considering at least a portion of a margin capacity of the at least one first battery module as an available capacity, by executing the at least one instruction.

According to still another aspect, there is provided a non-transitory computer-readable recording medium in which a program for executing the method is recorded.

Detailed descriptions of other example embodiments are included in the detailed description and drawings.

### Effects of the Invention

One or more of the following effects may be expected when a suggested example embodiment is applied.

According to the example embodiments, by managing SoH based on a margin capacity of a battery module, a module which is not replaced may have a SoH similar to that of a replaced module, and thereby able to use the replaced module without wasting its performance potential.

According to the example embodiments, it is possible to prevent SoH decrease of the entire battery pack even when a battery module ages more rapidly than another module, by managing the SoH based on a margin capacity of a battery module.

According to the example embodiments, it is also possible to optimize battery lifespan while maintaining uniform performance, by managing so that overall States of Health (SoHs) of the battery modules are similar to each other, based on margin capacities of the battery modules.

Effects of the present disclosure are not limited to those described above, and other effects may be made apparent to those skilled in the art from the following description.

### Brief Description of Drawings

FIG. 1 shows an interworking relationship between a battery management system for managing a battery State of Health (SoH) and a battery pack, according to an example embodiment.
FIG. 2 is a flowchart illustrating a SoH management method according to an example embodiment.
FIGS. 3A and 3B are example drawings illustrating a change in SoH through a SoH reconfirmation process, according to an example embodiment.
FIGS. 4A and 4B are example drawings illustrating a change in SoH through a SoH reconfirmation process, according to an example embodiment.
FIGS. 5A and 5B are example drawings illustrating a change in SoH when a battery module is replaced, according to an example embodiment.
FIG. 6 shows an interworking relationship between a battery management system for managing a battery State of Health (SoH) and a battery pack designed using a different method, according to an example embodiment.
FIG. 7 is a block diagram of a battery management system according to an example embodiment.

### Mode for Carrying Out the Invention

Terms used in the example embodiments are selected, as much as possible, from general terms that are widely used at present while taking into consideration the functions obtained in accordance with the present disclosure, but these terms may be replaced by other terms based on intentions of those skilled in the art, customs, emergence of new technologies, or the like. Also, in a particular case, terms that are arbitrarily selected by the applicant of the present disclosure may be used. Accordingly, it should be noted that the terms used herein should be construed based on practical meanings thereof and the whole content of this specification, rather than being simply construed based on names of the terms.

In the entire specification, when an element is referred to as "comprising" or "including" another element, the element should not be understood as excluding other elements as long as there is no special conflicting description, and the element may include at least one other element.

Throughout the specification, expression "at least one of a, b, and c" may include 'a only', 'b only', 'c only', 'a and b', 'a and c', 'b and c', or 'all of a, b, and c'.

The "terminal" referred hereinafter may be embodied as a computer of a portable device that can access a server or another terminal through a network. In the present disclosure, a computer may include, for example, a notebook computer, a desktop computer, and a laptop equipped with a web browser, and a portable device, for example, as a wireless communication device that guarantees portability and mobility, may include all kinds of handheld wireless communication devices such as a communication-based terminal, a smartphone, and tablet PC, supporting international mobile telecommunication (IMT), code division multiple access (CDMA), w-code division multiple access (W-CDMA), long-term evolution (LTE), and the like.

In the following description, example embodiments of the present disclosure will be described in detail with reference to accompanying drawings so that those skilled in the art can easily carry out the present disclosure. The present disclosure may be applied in many different forms and is not limited to the embodiments described herein.

Hereinafter, example embodiments of the present disclosure will be described in greater detail with reference to the drawings.

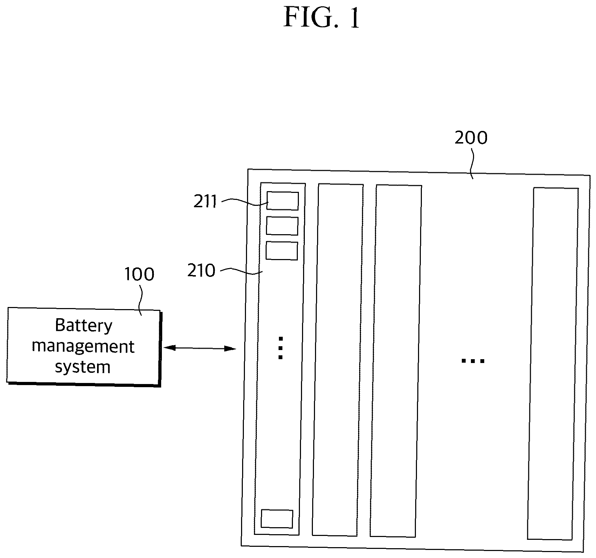

FIG. 1 shows an interworking relationship between a battery management system for managing a battery State of Health (SoH) and a battery pack, according to an example embodiment.

Referring to FIG. 1, a battery management system 100 may include a computing device, sensor, and other various equipment used for managing a battery pack 200. Here, the sensor may include various types of sensors used for managing a battery, such as a current sensor, voltage sensor, temperature sensor, insulation resistance sensor, and state detection sensor, and the equipment may include a communication interface, balancing circuit, and the like, but this is not limited thereto.

The battery pack 200 may include a plurality of battery modules, and each battery module may include a plurality of battery cells. More specifically, as shown in FIG. 1, a battery module 210 may include a battery cell 211.

According to an example embodiment, the battery pack 200 may be a battery pack designed to supply power corresponding to a predetermined capacity. Here, although generally the battery pack 200 is designed to be able to supply more power than the predetermined capacity in theory, it may be set to supply power only up to the predetermined capacity when being used. For example, when the battery pack 200 is planned to be used as a battery that is capable of supplying rated power from a 1000 Wh capacity, it may actually be designed to be able to supply power from a 1200 Wh capacity. That is, the battery pack 200, while designed to have a margin capacity, may be configured by the battery management system 100 to use only the initial capacity, which is the total capacity minus the margin capacity. Regarding the example described above, the total capacity, margin capacity, and initial capacity may be 1200Wh, 200 Wh, and 1000 Wh, respectively, and the battery pack 200 may be set to use the initial capacity of 1000Wh by the battery management system 100. The settings of the capacity of the battery pack 200 may be carried out to have a margin to guarantee safety during use and power output required in terms of quality management.

According to an example embodiment, the battery pack 200 may age depending on its usage. The degree of battery aging may be identified through the value of battery State of Health (SoH) calculated as a ratio of an available capacity at a given time to an initial available capacity of the battery pack 200. For example, when the initial capacity of the battery pack is set as 1000 Wh, as described above, the available capacity may be measured as 1000 Wh initially, however, if the available capacity is reduced to 950 Wh as the battery pack 200 is used, the SoH of the battery pack at the given time may be calculated as 95 percent (%). According to a related art, the margin capacity may not be considered in such a SoH calculation.

Also, the SoH of the battery pack 200 is not measured by simply adding available capacity of each battery module included in the battery pack 200 and calculating a ratio to the initial available capacity. More specifically, to calculate the SoH of the battery pack 200, SoH of each battery module included therein may be identified, and the lowest SoH among SoH of each of the battery modules may be identified as the SoH of the battery pack 200. For example, when there are 10 battery modules with initial capacity of 100 Wh, and a battery module with the best condition has available capacity of 97Wh, corresponding to a SoH of 97 %, and a battery module with the worst condition has only 85 Wh, corresponding to a SoH of 85 %, the SoH of the battery pack 200 is measured as 85 %, and be managed and used based on the low SoH value. The related art method of measuring and managing SoH has its benefits, however, it may be inefficient in that battery modules with higher available capacities cannot fully utilize their performance potential. Additionally, since the margin capacity is not considered in the SoH measurement, this inefficiency may worsen.

According to an example embodiment, the battery pack 200 may be used more efficiently by measuring SoH of each battery module by considering the margin capacity, and estimating SoH of the battery pack 200 based on the SoH of the battery module measured by considering the margin capacity. The SoH management method will be described hereinafter.

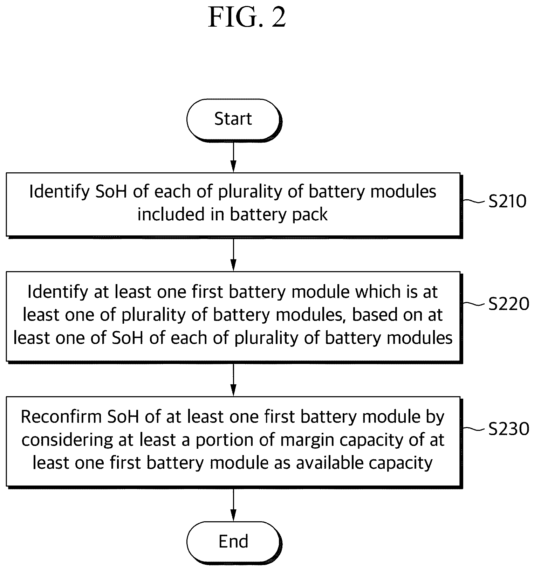

FIG. 2 is a flowchart illustrating a SoH management method according to an example embodiment.

Referring to FIG. 2, in operation S210, the battery management system 100 may identify SoH of each of a plurality of battery modules included in the battery pack 200. In operation S220, the battery management system 100 may identify at least one first battery module which is at least one of the plurality of battery modules, based on at least one of the SoH of each of the plurality of battery modules. In operation S230, the battery management system 100 may reconfirm SoH of the at least one first battery module by considering at least a portion of a margin capacity of the at least one first battery module as an available capacity. Hereinafter, each operation will be described in greater detail.

First, as described above, the battery management system100 may identify SoH of each battery module. Here the SoH may be identified in various ways. For example, the SoH may be identified using various methods, such as charge/discharge capacity measurement, internal resistance measurement, voltage analysis, Coulombic Efficiency measurement, impedance spectroscopy, and estimation method using intellectual intelligence, based on aforementioned sensors and equipment, but it is not limited thereto.

Then, the battery management system 100 may identify a first battery module based on at least one of the SoH of each of the plurality of battery modules. Example embodiments for identifying the first battery module will be described individually hereinafter.

First, according to an example embodiment, the battery management system 100 may confirm that at least one piece of difference information between the SoH of each of the plurality of battery modules is equal to or greater than a first threshold value, based on at least one of the SoH of each of the plurality of battery modules. For example, when there are 10 battery modules, difference information between SoHs may be calculated for 45 different combinations, and at least one of the 45 combinations may be confirmed to be equal to or greater than the first threshold value. The battery management system 100 may, among two battery modules corresponding to each of at least one piece of difference information with a difference equal to or greater than the first threshold value, identify at least one module with a relatively small SoH as the at least one first battery module. For example, there will be a battery module with higher SoH and a battery module with lower SoH in a combination of which the difference information is equal to or greater than the first threshold value, and the battery module with lower SoH may be identified as the first battery module. More specifically, when the first threshold value corresponds to 5 %, and battery modules of a combination have SoH of 91 % and 85 %, respectively, the combination corresponds to the difference information equal to or greater than the first threshold value, and here, the battery module with SoH of 85 % may be identified as the first battery module described above.

According to an example embodiment, the first threshold value may be set to be a predetermined value for verifying that a module is aging faster than another module, and it could be about 5 %, to give a specific figure, however, it shall not be limited to such a figure. The above method of identifying the first battery module may be basically for identifying a battery module with a decreasing SoH due to a faster aging rate compared to another battery module, and therefore, methods other than the above-described method may be applied as long as the same purpose can be achieved.

Then, the battery management system 100 may identify a first SoH corresponding to remaining battery modules, excluding the at least one battery module, among the plurality of battery modules. According to an example embodiment, the battery management system 100 may identify a value that may represent SoH of the remaining battery modules as the first SoH. For example, an average or median value, or the like of SoHs of the remaining battery modules may be identified as the first SoH, but it is not limited thereto. The battery management system 100, based on the first SoH, may identify at least a portion of a capacity to be considered as an available capacity, from a margin capacity. As an example, the battery management system 100 may calculate difference information between the available capacity of the first battery module at a given time and a capacity corresponding to the first SoH, compare the size between the difference information and the margin capacity, and if the difference information is smaller than the margin capacity, identify an amount corresponding to margin capacity minus the difference information as the available capacity. When the difference information is greater than the margin capacity, the entire margin capacity may be identified as the available capacity. More specifically, when the available capacity of the first battery module at a given time is 84 Wh and the first SoH is 91 %, the difference information between the available capacity and the capacity of 91 Wh corresponding to the first SoH may be calculated as 7 Wh. When the margin capacity is 20 Wh, the battery management system 100 may identify 7 Wh of the 20Wh margin capacity, which corresponds to the difference information, as the available capacity of the first battery module. If the margin capacity is 5 Wh, the entire 5 Wh may be identified as the available capacity of the first battery module. The identification process may be performed for each first battery module.

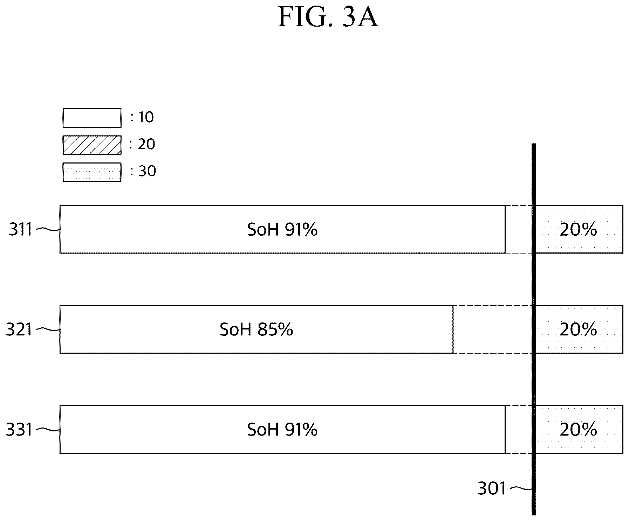

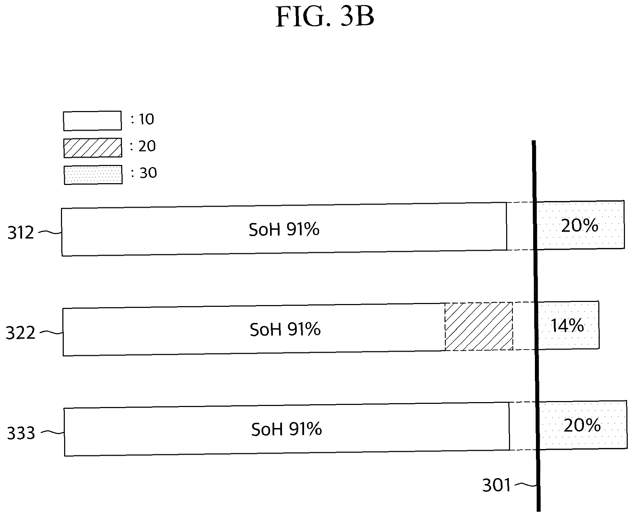

Then, the battery management system 100 may reconfirm SoH of the at least one first battery module based on the at least a portion of a capacity to be considered as the available capacity, from the margin capacity. For example, the battery management system 100 may add the at least a portion of a capacity to be considered as the available capacity, from the margin capacity, to the available capacity identified before applying the margin capacity, and reconfirm SoH of the first battery module based on a ratio comparing the total capacity with an initial available capacity. The process may be performed for each first battery module. Using the figures of the above-described example as an example again, the battery management system 100 may reconfirm SoH based on 91 Wh, which is the capacity after adding 7 Wh, the newly considered available capacity, to the available capacity of 84 Wh, the capacity of the first battery module before applying the margin capacity. The change in SoH through the SoH reconfirmation process is shown in FIGS. 3A and 3B. In FIGS. 3A through 5A, and FIGS. 3B through 5B, a white square 10 may indicate SoH of each battery module of which a SoH reconfirmation process according to an example embodiment of the present disclosure is not applied, and a dotted square 30 may indicate the margin capacity, and a hatched square 20 may indicate a capacity of the margin capacity considered as the available capacity. In addition, FIGS. 3A through 5A may not include the hatched square 20, as are illustrating battery SoHs before the SoH reconfirmation process of an example embodiment of the present disclosure is applied.

FIGS. 3A and 3B are example drawings illustrating a change in SoH through a SoH reconfirmation process, according to an example embodiment.

Referring to FIG. 3A, it is shown that modules 311, 321, and 331, before going through the SoH reconfirmation process have SoH of 91 %, 85 %, and 91 %, respectively, reduced from an initial available capacity 301 of SoH 100 %, as they have been used. Here, according to a related art, a battery pack including the modules 311, 321, and 331 may be used and managed based on SoH of 85 %, which is the same SoH as the second module 321. However, each battery module is designed to have a margin capacity, and using the battery pack based on SoH of 85 %, without using the 20 % margin capacity, may be a waste of performance potential.

Referring to FIG. 3B, an example of a case in which the waste of performance potential that may occur in the case shown in FIG. 3A is prevented, by applying the SoH management method according to the present disclosure, is shown. For example, a second module 322 which the SoH has been reconfirmed after applying the margin capacity, now has SoH of 91 %, as same as the other modules 312 and 332, by considering 6 %p of the margin capacity as the available capacity. Through this, the battery pack is used and managed as having SoH of 91 %, and the waste of performance potential may be prevented.

Hereinafter, another example embodiment of identifying the first battery module will be described.

According to an example embodiment, the battery management system 100 may confirm that at least one of the SoH of each of the plurality of battery modules is equal to or less than the second threshold value, based on at least one of the SoH of each of the plurality of battery modules. Then, at least one battery module corresponding to the SoH that is equal to or less than the second threshold value may be identified as the at least one first battery module. Here, the second threshold value may correspond to a SoH value at which a battery is considered aged, and needs a replacement. The value may be around 80 %, to give a more specific figure, but it is not limited thereto. According to the example embodiment, a battery module with SoH that fell below a threshold value related to the aging of a battery may be selected as the first battery module.

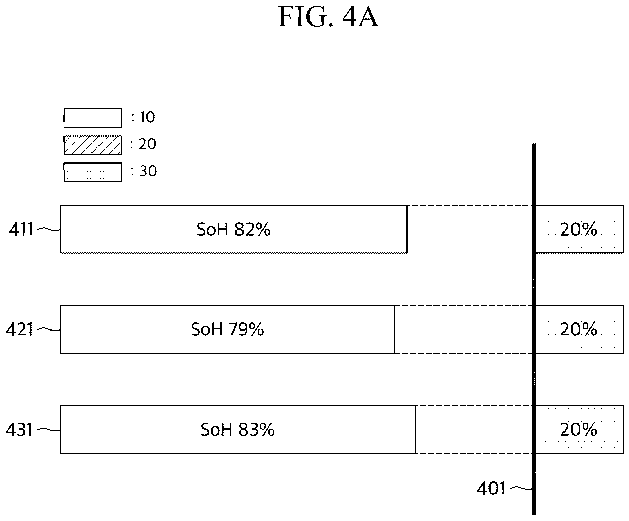

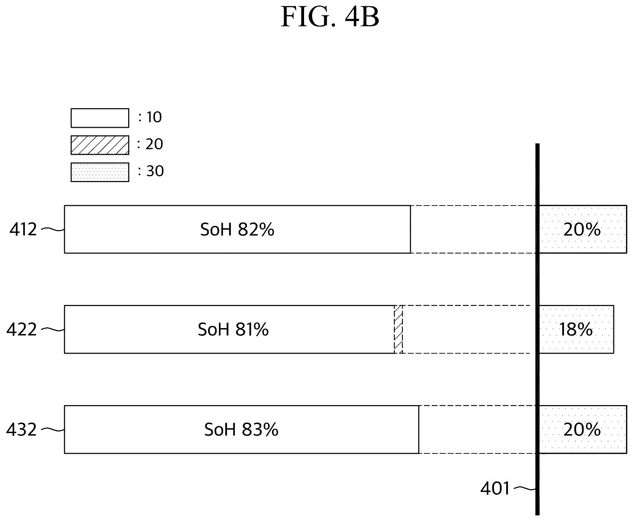

Here, the battery management system 100, similar to that of the above-described process, may identify at least a portion of a capacity to be considered as an available capacity, from a margin capacity. Then, based on the at least a portion of a capacity, SoH of the first battery module may be reconfirmed. Here, the at least a portion of a capacity to be considered as the available capacity from the margin capacity may be determined by, calculating, similar to that of the above description, difference information between a value corresponding to a SoH of remaining modules excluding the first battery module, with SoH of the first battery module, comparing the difference information with the margin capacity of the first battery module, and considering the smaller one among the two as the available capacity. Alternatively, as another example embodiment, the battery management system 100 may calculate difference information between the second threshold value and SoH of the first battery module, compare the difference information with the margin capacity of the first battery module, and consider the smaller one among the two as the available capacity. The SoH reconfirmation process may be performed by carrying out such a process for each first battery module. The change in SoH through the SoH reconfirmation process is shown in FIGS. 4A and 4B.

FIGS. 4A and 4B are example drawings illustrating a change in SoH through a SoH reconfirmation process, according to an example embodiment.

Referring to FIG. 4A, it is shown that modules 411, 421, and 431, before going through the SoH reconfirmation process, have SoH of 82 %, 79 %, and 83 %, respectively, reduced from an initial available capacity 401 of SoH 100 %, as they have been used. Here, according to a related art, a battery pack including the modules 411, 421, and 431 may be perceived as in need of replacement due to aging of the battery pack, as the SoH of 79 % of a second module 421 is estimated as the SoH of the battery pack. However, each battery module is designed to have a margin capacity, and when a battery pack is replaced without utilizing the margin capacity, it may as well be wasting the remaining margin capacity.

Referring to FIG. 4B, an example of a case in which the waste of margin capacity that may occur in the case shown in FIG. 4A is prevented, by applying the SoH management method according to the present disclosure, is shown. For example, as the SoH of a second module 422 is reconfirmed to be 81 % after applying 2 %p of the margin capacity as the available capacity, the battery pack is estimated to have SoH higher than 80 %, which is the SoH value at which the battery pack is considered aged, and needs a replacement, and thereby, leading to a longer lifespan of the battery pack without replacement.

The two methods of identifying the first battery module described above may be applied together. For example, a battery module of which SoH is decreasing more rapidly than another battery module may be identified as the first battery module through a selection based on the first threshold value, or a battery module determined to be aged may be identified as the first battery module through a selection based on the second threshold value, and apply the SoH reconfirming method of the present disclosure described above. Accordingly, by reconfirming the SoH after applying the margin capacity to the battery module which is determined to be aging faster than another battery module, or aged, the efficiency in terms of utilization and management of the battery pack may be improved.

In addition, the SoH reconfirming method of the present disclosure may be performed continually during the use of a battery pack. For example, examples shown in FIGS. 3 and 4 all illustrate cases in with the margin capacity, which was initially 20 % before use, is applied for the first time, however, an example embodiment in which the margin capacity is applied continually in sequential order may also be possible. For example, in the example shown in FIG. 3B, if SoH of the second battery module 322 becomes 6 %p lower than modules 312 and 332 again, the SoH may be readjusted by applying additional margin capacity corresponding to SoH of 6 %. Accordingly, the margin capacity may decrease to a capacity corresponding to 8 %. Similarly, in the example shown in FIG. 3B, if SoH of the second module 422 decreases to 79 %, the SoH may be adjusted to 81 % by applying the margin capacity corresponding to SoH of 2 %. Accordingly, the margin capacity may decrease to a capacity corresponding to 16 %. In the examples of FIGS. 3B and 4B, it is also possible that the margin capacity is applied to battery modules other than the second battery modules 322 and 422.

While continually consuming the margin capacity, the battery management system 100 may confirm that at least one of the plurality of battery modules has SoH equal to or less than the second threshold value and confirm that a percentage of margin capacity to be considered as available capacity of the at least one battery module corresponding to the SoH equal to or less than the second threshold value is equal to or greater than a third threshold value. Accordingly, the battery management system 100 may forward difference information related to a replacement of the battery pack to an admin terminal. That is, the battery management system 100, when the percentage of margin capacity considered as the available capacity reaches or exceeds the third threshold value while utilizing and managing by applying the margin capacity and recalculating the SoH continually, that is, when the margin capacity is almost completely consumed, may imply the need of replacement of the battery pack by forwarding the difference information related to a replacement of the battery pack to the admin terminal. The efficiency may be guaranteed by maximizing the use of the battery pack's capacity up to its limit.

Hereinafter, another example embodiment related to a method of identifying the firsts battery module will be described.

According to an example embodiment, the battery management system 100 may confirm that at least one of SoH of each of the plurality of battery modules is below the second threshold value. The battery management system 100, may identify a battery module with a SoH equal to or greater than the second threshold value as the first battery module. In addition, it may confirm that at least one of battery modules except the first battery module is replaced with at least one second battery module. According to an example embodiment, the second battery module may be a new battery module installed to replace a remaining aged battery module excluding the first battery module, and may have SoH of 100 % or a value higher than a SoH of the aged battery module. Here, the replacement the remaining battery module with the second battery module may be performed as replacement information related to a replacement of at least one of remaining battery modules is forwarded to the admin terminal.

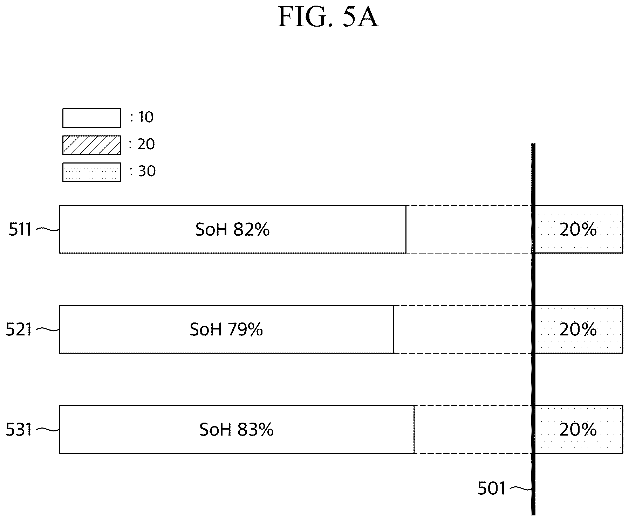

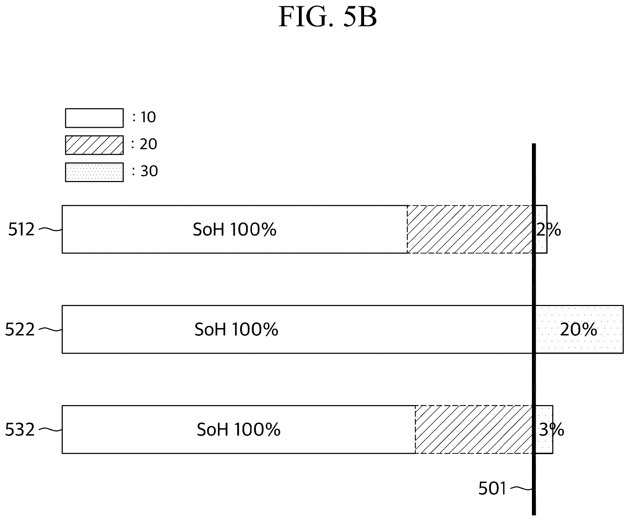

The battery management system 100 may identify a second SoH corresponding to a second battery module. Then, based on the second SoH, at least a portion of a capacity to be considered as available capacity, from margin capacity, may be identified. As an example, the battery management system may calculate difference information between the second SoH and SoH of the first battery module at a given time. Then, by comparing the difference information with the margin capacity, the capacity corresponding to the smaller value of the two may be considered as the available capacity, from the margin capacity. As an example, when the second SoH corresponds to 100 %, and SoH of the first battery module at a given time is 83 %, and the margin capacity is at its maximum amount corresponding to SoH of 20 %, the battery management system 100 may restore the SoH to 100 % by considering a capacity corresponding to SoH of 17 % as the available capacity, from the margin capacity. Similarly, as an example, when the second SoH corresponds to 95 %, and SoH of the first battery module at a given time is 87 %, the battery management system 100 may restore the SoH to 95 %, as same as the newly installed second battery module, by considering the capacity corresponding to 8 % as the available capacity, from the margin capacity. When only an amount corresponding to SoH of 5 % is remained as the margin capacity in the latter example, the entire remaining margin capacity, corresponding to SoH of 5 %, may be considered as the available capacity. Through SoH restoration of the battery module described above, the SoH of the entire battery pack may be restored, and thereby increasing the effectiveness of the battery pack replacement. Refer to FIGS. 5A and 5B to see its effect.

FIGS. 5A and 5B are example drawings illustrating a change in SoH when a battery module is replaced, according to an example embodiment.

Referring to FIG. 5A, battery modules 511, 521, and 531 have SoH of 82 %, 79 %, and 83 %, respectively, as the available capacity has been reduced from an initial available capacity 501 of SoH 100 %, as they have been used. Here, a second module 521 may be replaced as it has SoH of 79 %. However, according to a related art, when only the second battery module 521 is replaced, as SoH of other battery modules are 82 % and 83%, respectively, the SoH of the battery pack is still calculated as 82 % and utilized and managed based on that even when a new battery module is installed.

Referring to FIG. 5B, by applying the SoH management method according to the present disclosure, the SoH of the battery pack can be restored to 100 % even when only the second battery module 521 is replaced in a case identical to that of FIG. 5A. That is, when the second module 522 is replaced with a new one, the battery management system 100 may allow all battery modules of the battery pack to have SoH of 100 % or a value close to 100 %, by applying the margin capacity to a first battery module 512 and a third battery module 523. Accordingly, the SoH of the battery pack may be increased efficiently, even when replacing only one battery module.

The example embodiment of identifying the first battery module in accordance with the replacement of the battery module described above, and the example embodiment of identifying the first battery module based on the first threshold value and the second threshold value described earlier, may be applied together. For example, after reconfirming the SoH continually during the use of the battery, by applying the margin capacity to a battery module of which SoH is decreasing more rapidly than another battery module, or to an aged battery module, when the aged battery module is replaced, the effect of the replacement of the battery module may be maximized by applying the margin capacity to the other battery module.

According to an example embodiment, when a SoH is reconfirmed according to the above-described example embodiments, the battery management system 100 may control so that each battery module and battery pack 200 is used based on the reconfirmed SoH. That is, the first battery module may be controlled to use its capacity up to an amount corresponding to the reconfirmed SoH. Here, since the SoH of the first battery module too may be determined by the lowest SoH of a battery cell included therein, the battery management system 100 may control so that each battery cell included in the first battery module uses its capacity up to an amount corresponding to the reconfirmed SoH.

Although the SoH management method of the present disclosure described above has been described based on a case where a battery module is optimized by applying the margin capacity and optimizing the battery pack accordingly, the method may be applied in other cases as well. As an example, the SoH management method of the present disclosure may be applied to a case in which a battery cell, instead of a battery module, is optimized by applying the margin capacity, and thereby optimizing a battery module instead of a battery pack. Since the relationship between the battery pack and module is hierarchical similar to the relationship between the battery module and cell, the SoH management method of the present disclosure may be applied similarly.

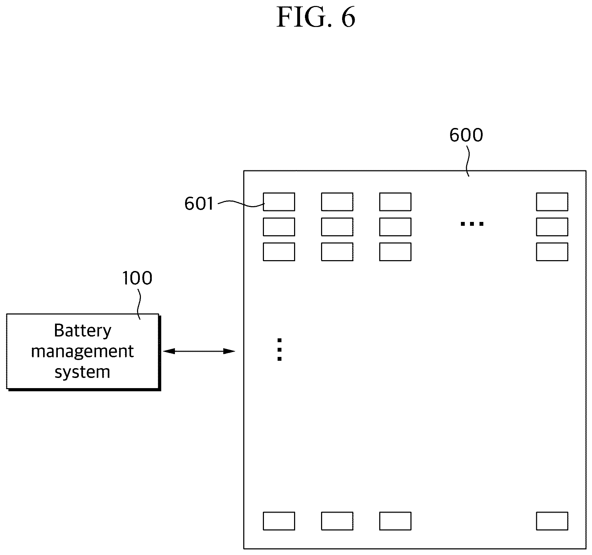

Additionally, the SoH management method of the present disclosure may be applied to a battery that does not have a cell-module-pack hierarchical structure, as described above. An example embodiment will be described with reference to FIG. 6.

FIG. 6 shows an interworking relationship between a battery management system for managing a battery State of Health (SoH) and a battery pack designed using a different method, according to an example embodiment.

Referring to FIG. 6, the battery management system 100 may manage SoH of a battery pack designed to have a cell-to-pack (CTP) structure. Here, the CTP structure is a structure that a battery cell is integrated into a battery pack without a module-unit assembly process, and has recently drawn attentions as it provides and allows for improved energy density, simplified manufacturing process, reduction in weight, and improved cooling system efficiency. The SoH management system according to the present disclosure may be applied to a battery pack 600 with such a CTP structure. As an example, the battery pack 600 having the CTP structure may be determined based on the lowest SoH among SoHs of a plurality of battery cells 601, and in this case, in accordance with the SoH management method according to the example embodiments described above, the lowest SoH may be increased by applying the margin capacity. As described above, by applying the SoH management method of the present disclosure, the performance of the battery pack 600 having the CTP structure may be improved and increase its lifespan.

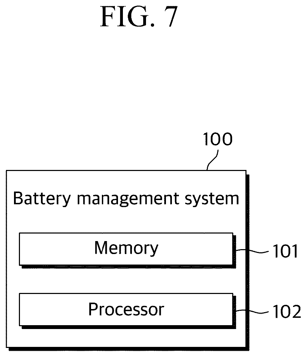

FIG. 7 is a block diagram of a battery management system according to an example embodiment.

The battery management system 100 may include a memory 101 and a processor 102 according to an example embodiment. Only components related to the battery management system 100 are illustrated in FIG. 7. Therefore, it is to be understood by those skilled in the art that other general-purpose components may be further included in addition to the components illustrated in FIG. 7. Also, according to example embodiments, the processor 102 may be included in a controller.

The processor 102 may control overall operations of the battery management system 100 and process data and a signal. The processor 102 may be configured as at least one hardware unit. Also, the processor 102 may be operated by one or more software modules generated by executing a program code stored in the memory 101. Since the processor 102 may include a memory, the processor 102 may control overall operations of the battery management system 100 and process data and a signal by executing a program code stored in the memory.

The processor 102, by executing at least one instruction, may identify SoH of each of a plurality of battery modules, identify at least one first battery module which is at least one of the plurality of battery modules, based on at least one of the SoH of each of the plurality of battery modules, and reconfirm SoH of the at least one first battery module by considering at least a portion of a margin capacity of the at least one first battery module as an available capacity.

According to an example embodiment, the battery management system 100 may also include a transceiver for wire/wireless communication. The battery management system 100 may communicate with an external battery management system using the transceiver. The external battery management system may be a terminal or a server. In addition, communication technologies supported by the transceiver may include global system for mobile communication (GSM), code division multi access (CDMA), long term evolution (LTE), wireless-fidelity (Wi-Fi), Bluetooth^{™}, radio frequency identification (RFID), infrared data association (IrDA), zigBee, near field communication (NFC), and the like.

The battery management system according to the above-described example embodiments may include a processor, a memory for storing program data and executing the stored program data, a permanent storage, such as a disk drive, a communications port for communicating with external devices, a user interface device, such as a touch panel, a key, and a button. Methods realized by software modules or algorithms may be stored in a computer-readable recording medium as computer-readable codes or program commands which may be executed by the processor. Here, the computer-readable recording medium may be a magnetic storage (such as a read-only memory (ROM), a random-access memory (RAM), a floppy disk, and a hard disk), an optical storage (such as a CD-ROM, and a digital versatile disc (DVD)), and the like. The computer-readable recording medium may be dispersed to computer systems connected by a network so that computer-readable codes may be stored and executed in a dispersion manner. The medium may be read by a computer, stored in a memory, and executed by a processor.

The example embodiments may be represented by functional blocks and various processing steps. These functional blocks may be implemented by various numbers of hardware and/or software configurations that execute specific functions. For example, the example embodiments may adopt direct circuit configurations such as a memory, a processor, a logic circuit, and a look-up table that may execute various functions by control of one or more microprocessors or other control devices. Similar to how elements may be executed by software programming or software elements, the example embodiments may be implemented by programming or scripting languages such as C, C++, Java, and assembler including various algorithms implemented by combinations of data structures, processes, routines, or of other programming configurations. Functional aspects may be implemented by algorithms executed by one or more processors. In addition, the example embodiments may adopt the related art for electronic environment setting, signal processing, and/or data processing, for example. The terms "mechanism", "element", "means", and "configuration" may be widely used and are not limited to mechanical and physical components. These terms may include meaning of a series of routines of software in association with a processor, for example.

The example embodiments described above are merely examples and other embodiments may be implemented within the scope of the following claims.

## Claims

1. A battery State of Health (SoH) management method of a battery management system, the method comprising:
identifying SoH of each of a plurality of battery modules included in a battery pack;
identifying at least one first battery module of the plurality of battery modules, based on at least one of the SoH of each of the plurality of battery modules; and
reconfirming SoH of the at least one first battery module by considering at least a portion of a margin capacity of the at least one first battery module as an available capacity.

2. The method of claim 1, wherein the identifying the at least one first battery module comprises:
confirming that at least one piece of difference information between the SoH of each of the plurality of battery modules is equal to or greater than a first threshold value, based on the at least one of the SoH of each of the plurality of battery modules; and
identifying at least one battery module below a SoH among battery modules corresponding to each of the at least one piece of difference information that is equal to or greater than the first threshold value as the at least one first battery module.

3. The method of claim 1, wherein the identifying the at least one first battery module comprises:
confirming that at least one of the SoH of each of the plurality of battery modules is equal to or less than a second threshold value, based on the at least one of the SoH of each of the plurality of battery modules; and
identifying at least one battery module corresponding to the SoH that is equal to or less than the second threshold value as the at least one first battery module.

4. The method of claim 1, wherein the reconfirming SoH of the at least one first battery module comprises:
identifying a first SoH corresponding to remaining battery modules, excluding the at least one first battery module, among the plurality of battery modules;
identifying, based on the first SoH, at least a portion of a capacity to be considered as the available capacity, from the margin capacity; and
reconfirming SoH of the at least one first battery module based on the at least the portion of the capacity to be considered as the available capacity.

5. The method of claim 1, further comprising:
confirming that at least one SoH of the plurality of battery modules is equal to or less than a second threshold value;
confirming that a percentage of a margin capacity considered as an available capacity of at least one battery module corresponding to the SoH that is equal to or less than the second threshold value is equal to or greater than a third threshold value; and
forwarding replacement information related to a replacement of the battery pack to an admin terminal.

6. The method of claim 1, wherein the identifying the at least one first battery module comprises:
confirming that at least one of the SoH of each of the plurality of battery modules is below a second threshold value; and
confirming that at least one of remaining battery modules, excluding the at least one first battery module with SoH equal to or greater than the second threshold value, among the plurality of battery modules, is replaced with at least one second battery module.

7. The method of claim 6, wherein the confirming that at least one of the SoH of the plurality of battery modules is below the second threshold value comprises forwarding replacement information related to a replacement of the at least one of the remaining battery modules to an admin terminal.

8. The method of claim 6, wherein the reconfirming SoH of the at least one first battery module comprises:
identifying a second SoH corresponding to the at least one second battery module;
identifying, based on the second SoH, at least a portion of a capacity to be considered as the available capacity, from the margin capacity; and
reconfirming SoH of the at least one first battery module based on the at least the portion of the capacity to be considered as the available capacity.

9. A non-transitory computer-readable recording medium in which a program for executing a method of any one of claims 1 through 8 claim 1 is recorded.

10. A battery management system for managing a battery State of Health (SoH), the system comprising:
a processor; and
a memory configured to store at least one instruction,
wherein the processor is configured to:
identify SoH of each of a plurality of battery modules included in a battery pack;
identify at least one first battery module of the plurality of battery modules, based on at least one of the SoH of each of the plurality of battery modules; and
reconfirm SoH of the at least one first battery module by considering at least a portion of a margin capacity of the at least one first battery module as an available capacity, by executing the at least one instruction.
